# EUROPÄISCHE PATENTANMELDUNG

(11) **EP 4 822 213 A1**
(43) Veröffentlichungstag der Anmeldung: **14.10.2026**
(21) Anmeldenummer: 26153208.9
(22) Anmeldetag: 21.01.2026
(51) Int. Cl.: F16G 13/16, F16L 3/01, H02G 11/00

(54) **BEWEGUNGSVORRICHTUNG**

(30) Priorität: 09.04.2025 DE 102025001197
(71) Anmelder: Dr. Johannes Heidenhain GmbH, 83301 Traunreut (DE)
(72) Erfinder: PLETSCHACHER, Bernhard, 83339 Chieming (DE)

(57) **Zusammenfassung**

Die Erfindung betrifft eine Bewegungsvorrichtung (1) mit flexiblem Leitungssystem, umfassend einen ersten Träger (3), wenigstens einen zweiten Träger (4), eine Basis (2) und wenigstens eine Versorgungsleitung (5). Der zweite Träger (4) ist relativ zur Basis (2) in einer Bewegungsrichtung (B) verfahrbar und der erste Träger (3) ist relativ zum zweiten Träger (4) in der Bewegungsrichtung (B) verfahrbar. Der erste Träger (3), der zweite Träger (4) und die Basis (2) sind senkrecht zur Bewegungsrichtung (B) zueinander beabstandet angeordnet. Die Versorgungsleitung (5) erstreckt sich von der Basis (2) über den zweiten Träger (4) hin zum ersten Träger (3). Die Länge der Versorgungsleitung (5) ist so bemessen, dass in jeder Verfahrposition des ersten und zweiten Trägers (3, 4) die Versorgungsleitung (5) zwischen dem zweiten Träger (4) und der Basis (2) wenigstens einen ersten Bogen (5.1) und zwischen dem ersten Träger (3) und dem zweiten Träger (4) wenigstens einen zweiten Bogen (5.2) ausbildet.

## Beschreibung

### GEBIET DER TECHNIK

Die Erfindung betrifft eine Bewegungsvorrichtung mit flexiblem Leitungssystem gemäß dem Anspruch 1 und ein Fertigungssystem mit entsprechender Bewegungsvorrichtung gemäß Anspruch 12.

Solche Bewegungsvorrichtungen kommen beispielsweise in der Halbleiterfertigung bei Fotolithografievorrichtungen oder Montagevorrichtungen für elektronische Bauteilkomponenten zum Einsatz. Teilweise sind hierbei große Verfahrwege in der X- und Y-Richtung notwendig, um verschiedene Arbeitsprozesse an unterschiedlichen Positionen im Arbeitsraum solcher Fotolithografieoder Montagevorrichtungen durchzuführen. Diese Verfahrwege erfordern den Einsatz langer Versorgungsleitungen, die die benötigte Energie und Signale zwischen den stationären und den beweglichen Teilen der Bewegungsvorrichtung übertragen.

Zu den typischen Arbeitsprozessen in der Halbleiterfertigung, bei denen solche Bewegungsvorrichtungen eingesetzt werden, gehören beispielsweise das Be- und Entladen von Wafern, das Vermessen und Belichten der Waferoberfläche sowie das Zerteilen der Wafer in Einzelchips und deren Verpacken in Gehäuse. Diese Prozesse erfordern präzise und hochdynamische Bewegungen an den Zielpositionen.

Ein Problem bei der Verwendung langer Versorgungsleitungen ist, dass sie aufgrund ihrer Länge und Massenträgheit schwer zu kontrollieren sind. Besonders bei zyklischen, kurzen Vor- und Zurückbewegungen neigen sie dazu aufzuschwingen, was die Präzision und Effizienz der Bewegungen beeinträchtigt.

### STAND DER TECHNIK

Aus der Offenlegungsschrift DE 10 2005 003 359 A1 ist eine elektronische Gerätekomponente mit einer Versorgungsleitung bekannt, welche S-förmig zwischen einem verfahrbaren Träger und einer Basis angeordnet ist. Mittels Begrenzungsplanken sowie träger- und basisfesten Grenzsteinen wird die Bewegungsfreiheit der Versorgungsleitung eingeschränkt, sodass ein minimaler Biegeradius der Versorgungsleitung nicht unterschritten wird.

Nachteilig am Stand der Technik ist, dass durch die Einschränkung der Bewegungsfreiheit der Versorgungsleitung durch die Begrenzungsmittel ein erhöhter Abrieb an der Versorgungsleitung entsteht. Dies kann einerseits zu Verschleißschäden an der Versorgungsleitung führen und andererseits zu einer Kontamination des Arbeitsraums mit Verschleißpartikeln.

### ZUSAMMENFASSUNG DER ERFINDUNG

Der Erfindung liegt die Aufgabe zugrunde ein Bewegungsvorrichtung mit flexiblem Leitungssystem zu schaffen, welches vergleichsweise verschleißarm ausgebildet ist und gleichzeitig eine vergleichsweise optimale Führung des flexiblen Leitungssystems ermöglicht.

Diese Aufgabe wird erfindungsgemäß durch die Merkmale des Anspruchs 1 gelöst. Vorteilhafte Ausgestaltungen und Weiterbildungen sind in den jeweils abhängigen Ansprüchen angegeben.

Ein Fertigungssystem mit mindestens einer erfindungsgemäßen Bewegungsvorrichtung ist in Anspruch 12 angegeben.

Die mit der Erfindung erzielten Vorteile bestehen insbesondere darin, dass kurze und lange Bewegungsabfolgen in der Bewegungsrichtung optimiert ausgeführt werden können und gleichzeitig die Vorrichtung weniger verschleißanfällig ist.

Die erfindungsgemäße Bewegungsvorrichtung mit flexiblem Leitungssystem umfasst einen ersten Träger, wenigstens einen zweiten Träger, eine Basis und wenigstens eine Versorgungsleitung. Der zweite Träger ist relativ zur Basis in einer Bewegungsrichtung verfahrbar und der erste Träger ist relativ zum zweiten Träger in der Bewegungsrichtung verfahrbar. Der erste Träger, der zweite Träger und die Basis sind senkrecht zur Bewegungsrichtung zueinander beabstandet angeordnet. Die Versorgungsleitung erstreckt sich von der Basis über den zweiten Träger hin zum ersten Träger. Die Länge der Versorgungsleitung ist so bemessen, dass in jeder Verfahrposition des ersten und zweiten Trägers die Versorgungsleitung zwischen dem zweiten Träger und der Basis wenigstens einen ersten Bogen und zwischen dem ersten Träger und dem zweiten Träger wenigstens einen zweiten Bogen ausbildet.

Es ist vorgesehen, dass ein Träger in einer Richtung senkrecht zur Bewegungsrichtung beabstandet zur Basis angeordnet ist und dass der andere Träger dazwischen angeordnet ist, wobei zwischen den beiden Trägern und der Basis jeweils ein Luftspalt ausgebildet ist. Insbesondere ist vorgesehen, dass der erste Träger, der zweite Träger und die Basis in unterschiedlichen parallel angeordneten Ebenen liegen.

Zudem kann der Abstand zwischen dem ersten Träger und dem zweiten Träger ungleich zum Abstand zwischen dem mittleren Träger und der Basis ausgebildet sein. Bevorzugt ist der Abstand zwischen dem ersten Träger und dem zweiten Träger kleiner als der Abstand zwischen dem mittleren Träger und der Basis.

Gemäß einer ersten vorteilhaften Weiterbildung der Erfindung ist der zweite Träger zwischen dem ersten Träger und der Basis angeordnet, wobei der erste Bogen und der zweite Bogen der Versorgungsleitung unterschiedlich gekrümmt ausgebildet sind.

Unter einer unterschiedlichen Krümmung ist zu verstehen, dass der erste Bogen und der zweite Bogen der Versorgungsleitung ein unterschiedliches Krümmungsverhalten aufweisen. Insbesondere kann das Krümmungsverhalten des ersten Bogens linksgekrümmt oder in alternativer Anordnung rechtsgekrümmt verlaufen und das Krümmungsverhalten des zweiten Bogens rechtsgekrümmt oder gemäß der alternativen Anordnung linksgekrümmt verlaufen.

Gemäß einer zweiten alternativen Weiterbildung der Erfindung ist der erste Träger zwischen dem zweiten Träger und der Basis angeordnet, wobei der erste Bogen und der zweite Bogen der Versorgungsleitung identisch gekrümmt ausgebildet sind.

Unter einer identischen Krümmung ist im Rahmen dieser Offenbarung zu verstehen, dass der erste Bogen und der zweite Bogen der Versorgungsleitung das gleiche Krümmungsverhalten aufweisen. Insbesondere kann das Krümmungsverhalten des ersten Bogens linksgekrümmt oder in alternativer Anordnung rechtsgekrümmt sein und das Krümmungsverhalten des zweiten Bogens ebenfalls linksgekrümmt oder gemäß der alternativen Anordnung ebenfalls rechtsgekrümmt sein. In weiterer Ausgestaltung ist die Versorgungsleitung zwischen der Basis und dem zweiten Träger länger ausgebildet als zwischen dem ersten Träger und dem zweiten Träger.

Mit Vorteil weist der erste Bogen der Versorgungsleitung einen größeren Krümmungsradius auf als der zweite Bogen der Versorgungsleitung. Mit Vorteil ist der Verfahrweg des ersten Trägers kleiner als der Verfahrweg des zweiten Trägers.

In weiterer Ausgestaltung umfasst die Versorgungsleitung wenigstens einen Lichtleiter.

In weiterer Ausgestaltung umfasst die Versorgungsleitung neben dem wenigstens einen Lichtleiter zusätzlich mehrere Kabelstränge, welche parallel zum Lichtleiter angeordnet sind.

Insbesondere kann die Versorgungsleitung beim Vorsehen von weiteren Lichtleitern oder vorsehen von Kabelsträngen in einem Flachkabelformat ausgebildet sein.

Unter dem Begriff Kabelstränge sind Übertragungsleitungen zu verstehen, die Gase, Energie, Daten usw. zwischen den beiden Trägern und der Basis und ergänzend oder alternativ wenigstens einem der Träger und der Basis übertragen können.

Mit Vorteil ist die Versorgungsleitung wenigstens zwischen dem ersten Träger und dem zweiten Träger freitragend ausgebildet.

In weiterer Ausgestaltung ist die Versorgungsleitung zumindest teilweise von einem Verschleißschutzmittel umgeben.

Gemäß einer Ausführungsvariante umfasst die Versorgungsleitung wenigstens ein Mittel zum Einhalten eines vorbestimmten Krümmungsintervalls.

Im Rahmen der Erfindung kann wenigstens eine erfindungsgemäße Bewegungsvorrichtung in einem Fertigungssystem zum Bearbeiten und ergänzend oder alternativ zum Prüfen von Halbeitersubstraten umfasst sein, welche Bewegungsabläufe in einer vorbestimmten Bewegungsrichtung ausführt.

Die Erfindung wird nachstehend auch hinsichtlich weiterer Merkmale und Vorteile anhand der Beschreibung von Ausführungsbeispielen und unter Bezugnahme auf die beiliegenden, schematischen Zeichnungen näher erläutert.

### KURZE BESCHREIBUNG DER ZEICHNUNGEN

Es zeigen
- Fig. 1: eine Seitenansicht einer Bewegungsvorrichtung mit flexiblem Leitungssystem gemäß einem ersten Ausführungsbeispiel in einer ersten Position;
- Fig. 2: eine Seitenansicht einer Bewegungsvorrichtung mit flexiblem Leitungssystem gemäß dem ersten Ausführungsbeispiel aus Fig. 1 in einer zweiten Position;
- Fig. 3: eine Seitenansicht einer Bewegungsvorrichtung mit flexiblem Leitungssystem gemäß einem zweiten Ausführungsbeispiel;
- Fig. 4: einen Querschnitt durch eine Versorgungsleitung;

### BESCHREIBUNG DER AUSFÜHRUNGSFORMEN

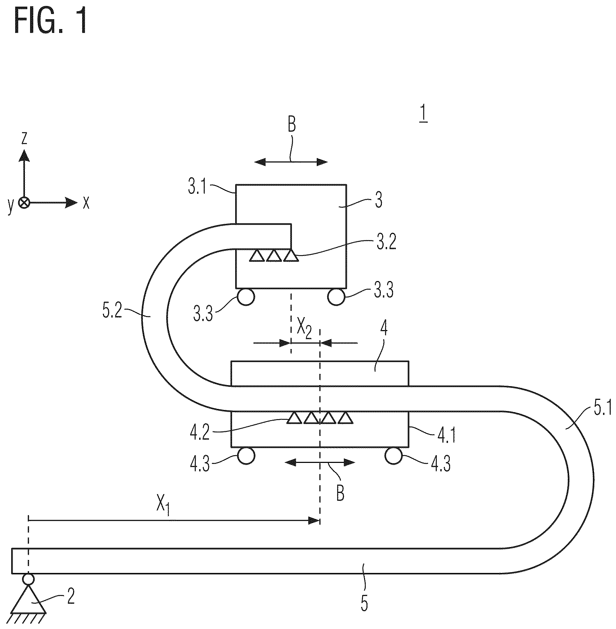

Die Fig. 1 veranschaulicht einen möglichen Aufbau einer erfindungsgemäßen Bewegungsvorrichtung 1 mit flexiblem Leitungssystem gemäß einem ersten Ausführungsbeispiel.

Die Bewegungsvorrichtung 1 umfasst eine stationäre Basis 2 sowie einen ersten verfahrbaren Träger, im Folgenden auch Kurzhub-Shuttle 3 genannt, und einen zweiten verfahrbaren Träger, im Folgenden auch Langhub-Shuttle 4 genannt. Das Langhub-Shuttle 4 und das Kurzhub-Shuttle 3 sind zur Basis 2 sowie zueinander in der z-Richtung beabstandet angeordnet, sodass die Basis 2, das Langhub-Shuttle 4 und das Kurzhub-Shuttle 3 jeweils in unterschiedlichen Ebenen liegen. Gemäß dem ersten Ausführungsbeispiel ist hierbei vorgesehen, dass das Langhub-Shuttle 4 zwischen der Basis 2 und dem Kurzhub-Shuttle 3 angeordnet ist.

Das Kurzhub-Shuttle 3 und das Langhub-Shuttle 4 sind entlang einer Bewegungsrichtung B, in Fig. 1 entspricht dies einer Bewegungsrichtung parallel zur x-Richtung, einzeln und ergänzend oder alternativ gemeinsam verfahrbar. Hierfür kann beispielsweise vorgesehen sein, dass das Langhub-Shuttle 4 und das Kurzhub-Shuttle 3 auf magnetischen, mechanischen oder pneumatischen Führungen definiert verfahrbar sind. Insbesondere ist vorgesehen, dass das Langhub-Shuttle 4 relativ zur Basis über lange Strecken in der Bewegungsrichtung B verfahren werden kann. Das Kurzhub-Shuttle 3 ist in der Bewegungsrichtung B für kurze Streckenabschnitte verfahrbar, insbesondere relativ zum Langhub-Shuttle 4.

Ausgehend von der Basis 2 erstreckt sich eine Versorgungsleitung 5 über das Langhub-Shuttle 4 zum Kurzhub-Shuttle 3. Die Versorgungsleitung 5 ist hierbei so ausgebildet, dass in jeder Verfahrposition von Langhub-Shuttle 4 und Kurzhub-Shuttle 3 zwischen der Basis 2 und dem Langhub-Shuttle 4 die Versorgungsleitung 5 einen ersten Bogen 5.1 ausgebildet und zwischen dem Langhub-Shuttle 4 und dem Kurzhub-Shuttle 3 einen zweiten Bogen 5.2 ausgebildet.

Die Versorgungleitung 5 kann sich entweder kontinuierlich von der Basis 2 über das Langhub-Shuttle 4 hin zum Kurzhub-Shuttle 3, wie in Fig. 1 bis 3 gezeigt, erstrecken oder alternativ diskontinuierlich erstrecken, d. h. eine Verbindung der beiden Shuttles 3, 4 erfolgt über eine erste Versorgungsleitung und über eine zweite Versorgungsleitung zwischen dem Langhub-Shuttle 4 und der Basis 2.

Gemäß dem ersten Ausführungsbeispiel in Fig. 1 sind der erste Bogen 5.1 und der zweite Bogen 5.2 unterschiedlich gekrümmt ausgebildet, d. h. die Versorgungsleitung 5 verläuft in S-Form. Der erste Bogen 5.1 ist linksgekrümmt ausgebildet und besitzt einen ersten Krümmungsradius R1, wohingegen der zweite Bogen 5.2 rechtsgekrümmt ausgebildet ist und einen zweiten Krümmungsradius R2 aufweist, welcher sich vom ersten Krümmungsradius R1 des ersten Bogens 5.1 unterscheidet. Insbesondere ist der erste Krümmungsradius R1 größer als der zweite Krümmungsradius R2.

Das zuvor beschriebene Krümmungsverhalten bezüglich einer Linkskrümmung bzw. Rechtskrümmung der Versorgungsleitung 5 bezieht sich auf die in Fig. 1 dargestellte Beobachtungsrichtung entlang der y-Richtung.

Das Langhub-Shuttle 4 dient zur Aufnahme eines Teilabschnitts der Versorgungsleitung 5 und umfasst ein Trägergestell 4.1 mit Durchführungsöffnungen für die Versorgungsleitung 5 und Mittel 4.2 zum Befestigen der Versorgungsleitung 5, sodass diese bei einer Auslenkung des Langhub-Shuttles 4 mittgenommen wird. Darüber hinaus umfasst das Langhub-Shuttle 4 Mittel 4.3 zum Führen des Langhub-Shuttles 4 in der vorgesehen Bewegungsrichtung B.

Das Kurzhub-Shuttle 3 dient zur Aufnahme eines weiteren Teilabschnitts der Versorgungsleitung 5, insbesondere eines Endabschnitts der Versorgungsleitung 5, und umfasst ein Trägergestell 3.1 mit mindestens einer Durchführungsöffnung für die Versorgungsleitung 5 und Mittel 3.2 zum Befestigen der Versorgungsleitung 5, sodass diese bei einer Auslenkung des Kurzhub-Shuttles 3 mittgenommen wird. Darüber hinaus umfasst das Kurzhub-Shuttle 3 Mittel 3.3 zum Führen des Kurzhub-Shuttles 3 in der vorgesehen Bewegungsrichtung B.

Die Basis 2 ist stationär ausgebildet und die Versorgungsleitung 5 ist mit dieser gekoppelt. Bei der Kopplung kann es sich um einen funktionalen Anschluss der Versorgungsleitung 5 handeln, sodass die Basis 2 beispielsweise als Quelle für eine Energieversorgung des Kurzhub-Shuttles 3 und des Langhub-Shuttles 4 über die Versorgungsleitung 5 dienen kann.

Beispielsweise kann vorgesehen sein, dass die Führungen 3.3 des Kurzhub-Shuttles 3 am Trägergestell 4.1 des Langhub-Shuttles 4 angeordnet sind, sodass beim Verfahren des Langhub-Shuttles 4 das Kurzhub-Shuttle 3 mitgenommen wird.

Die Führungen 3.3 und 4.3 können aus einer Linearführung beispielsweise in Form von Schienen und Gleit- oder Rolllagern ausgebildet sein. Zur besseren Veranschaulichung sind in den Fig. 1 bis 3 die Führungen 3.3, 4.3 ohne Linearführungen gezeigt.

Vorteilhafterweise befinden sich ein oder mehrere Wirkmittel, beispielsweise ein Waferchuck, Greifer oder Bonder, etc., am oder im Kurzhub-Shuttle 3 und ergänzend oder alternativ am oder im Langhub-Shuttle 4.

Durch das Vorsehen des Langhub-Shuttles 4 zwischen dem Kurzhub-Shuttle 3 und der Basis 2 ist es möglich Bewegungen entlang der Bewegungsrichtung B durch die Bewegungsvorrichtung 1 optimiert auszuführen. Lange Bewegungsabfolgen X1 werden hierbei durch das Langhub-Shuttle 4 ausgeführt und kurze Bewegungsabfolgen X2 durch das Kurzhub-Shuttle 3. Durch diese Aufteilung können nachteilhafte Reaktionskräfte abgefangen werden, da ein Aufbäumen der Versorgungsleitung 5 insbesondere bei hochdynamischen Bewegungen entfällt bzw. minimiert oder kompensiert werden kann.

Zudem kann der Abschnitt der Versorgungsleitung, welcher den zweiten Bogen 5.2 umfasst, bezüglich seiner Länge kürzer ausgebildet sein als jener Abschnitt der Versorgungsleitung 5, welcher den ersten Bogen 5.1 umfasst. Dadurch kann der Abschnitt, welcher den zweiten Bogen 5.1 umfasst, selbsttragend ausgebildet sein und es muss eine geringere Masse bewegt werden, wodurch wiederum eine Erhöhung der Anregungsfrequenz für das Kurzhub-Shuttle 3 möglich ist.

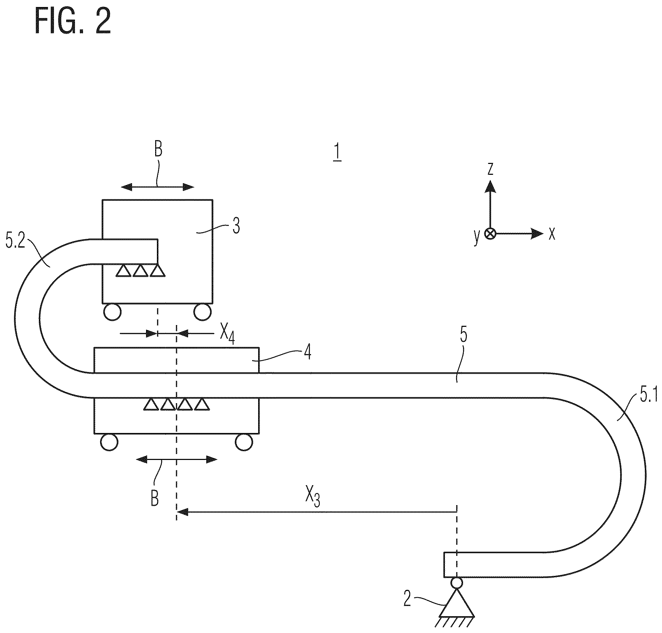

Fig. 2 zeigt die Bewegungsvorrichtung 1 aus Fig. 1 in einer weiteren, ausgelenkten Position. Dargestellt ist eine Auslenkung entgegen der x-Richtung. Die resultierende Auslenkung erfolgt für das Langhub-Shuttle 4 relativ zur Basis 2 mit X₃ und für das Kurzhub-Shuttle 3 relativ zum Langhub-Shuttle 4 mit X₄. Entsprechend beträgt die resultierende Gesamtauslenkung X_{Ges} von der Position in Fig.1 zur Position in Fig. 2 ${X}_{Ges} = \left({X}_{1}-{X}_{2}\right) + \left({X}_{3}+{X}_{4}\right) ;$

Obwohl die Gesamtauslenkung X_{Ges} einer vergleichsweise langen Bewegungsabfolge entspricht, bleibt durch eine Aufteilung in eine kurze Bewegungsabfolge und eine lange Bewegungsabfolge die bewegte Masse der Versorgungsleitung 5 auf einem niedrigen Niveau. Ein Aufschwingen insbesondere für zyklischen Bewegungen kann somit reduziert werden.

Ein weiterer Vorteil liegt darin, dass große Beschleunigungen reduziert werden können, da einzelne Abschnitte der Versorgungsleitung 5 zeitlich unabhängig angesteuert werden können. Somit ist es möglich große Beschleunigungen und den entsprechend daraus resultierende Impuls im System zu reduzieren.

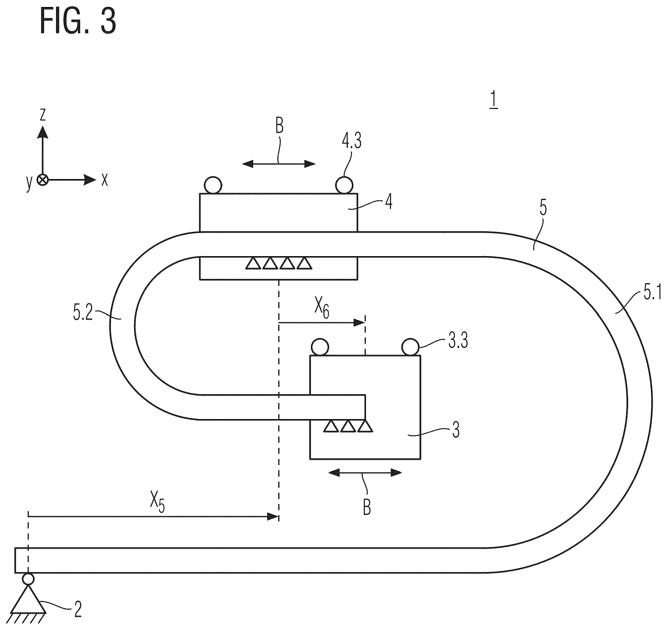

Fig. 3 zeigt ein zweites Ausführungsbeispiel der Bewegungsvorrichtung 1. Der Unterschied zum ersten Ausführungsbeispiel liegt dabei in der Positionierung des Kurzhub-Shuttles 3 zwischen dem Langhub-Shuttle 4 und der Basis 2. Entsprechend liegt bei der Versorgungsleitung 5 dann in den gekrümmten Abschnitten ein gleiches Krümmungsverhalten vor, d. h. sowohl der erste Bogen 5.1 als auch der zweite Bogen 5.2 der Versorgungsleitung 5 sind dann identisch gekrümmt. Für die in Fig. 3 eingenommene Betrachtungsrichtung liegt jeweils eine Linkskrümmung vor. Jedoch weisen der erste Bogen 5.1 und der zweite Bogen 5.2 weiterhin unterschiedliche Krümmungsradien (R1 ≠ R2) auf. Insbesondere ist der erste Krümmungsradius R1 größer als der zweite Krümmungsradius R2.

Bei einer Ausgestaltung der Bewegungsvorrichtung 1 gemäß dem zweiten Ausführungsbeispiel ist von Vorteil, dass eine Positionierung der Führung 4.3 des Langhub-Shuttles 4 und der Führung 3.3 des Kurzhub-Shuttles 3 überkreuzungsfrei mit der Versorgungsleitung 5 ermöglicht wird. Die Führungen 3.3 des Kurzhub-Shuttles 3 wird bevorzugt an der Unterseite des Trägergestells 4.1 des Langhub-Shuttles 4 angeordnet, sodass das Kurzhub-Shuttle relativ zum Langhub-Shuttle 4 verfahrbar ist. Die Führungen 4.3 des Langhub-Shuttles 4 werden dann oberhalb am Trägergestell 4.1 des Langhub-Shuttles angeordnet, sodass dieses relativ zur Basis in der Bewegungsrichtung B verfahrbar ist.

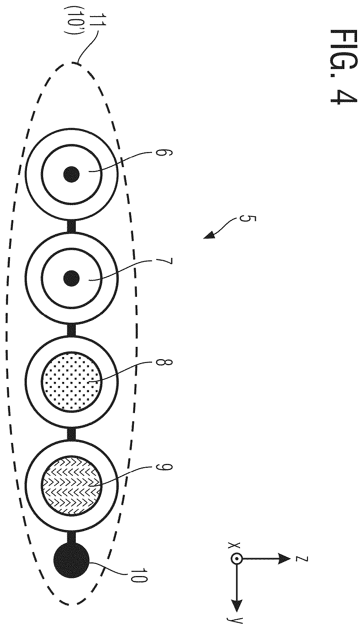

Fig. 4 zeigt einen Querschnitt durch die Versorgungsleitung 5, welche mehrere Kabelstränge zu einem Flachbandkabel zusammenfasst. Dabei umfasst die Versorgungsleitung 5 zwei Lichtleiter 6, 7 zur Übertragung von optischen Steuerbefehlen und ergänzend oder alternativ zum Speisen eines Abstrahlmittels. Zusätzlich kann die Versorgungsleitung weitere Kabelstränge umfassen, beispielsweise in Form einer Luftdruckleitung 8 und ergänzend oder alternativ einer Kupferleitung 9.

Zusätzlich kann die Versorgungsleitung 5 über ein oder mehrere Mittel 10, 10' zum Einhalten eines vorgestimmten Krümmungsintervalls verfügen, sodass ein vordefinierter minimaler bzw. maximaler Krümmungsradius im Bereich des erste und zweite Bogen 5.1, 5.2 der Versorgungsleitung 5 nicht über- bzw. unterschritten wird.

Bei dem Mittel 10, 10' kann es sich beispielsweise um einen Führungsdraht 10 handeln, welcher eine geeignete Biegesteifigkeit aufweist und ergänzend oder alternativ um Ummantelungssegmente 10' in Form einer Energieführungskette, welche entlang der Längserstreckung der Versorgungsleitung 5 ineinandergreifend angeordnet sein können.

Die Versorgungsleitung 5 kann ergänzend oder alternativ zum Mittel 10, 10' zum Einhalten eines vorgestimmten Krümmungsintervalls über ein Verschleißschutzmittel 11 verfügen, welches zumindest abschnittsweise die Versorgungsleitung 5 umgibt. Hierdurch kann sichergestellt werden, dass insbesondere bei harschen Umgebungsbedingungen ein Verschleiß der Versorgungsleitung 5 unterbunden bzw. minimiert wird.

## Patentansprüche

1. Bewegungsvorrichtung (1) mit flexiblem Leitungssystem, umfassend eine Basis (2), einen ersten und zweiten Träger (3, 4) und wenigstens eine Versorgungsleitung (5),
wobei der zweite Träger (4) relativ zur Basis (2) in einer Bewegungsrichtung (B) verfahrbar ist und der erste Träger (3) relativ zum zweiten Träger (4) in der Bewegungsrichtung (B) verfahrbar ist,
wobei der erste Träger (3), der zweite Träger (4) und die Basis (2) senkrecht zur Bewegungsrichtung (B) zueinander beabstandet angeordnet sind,
wobei sich die Versorgungsleitung (5) von der Basis (2) über den zweiten Träger (4) hin zum ersten Träger (3) erstreckt,
wobei die Länge der Versorgungsleitung (5) so bemessen ist, dass in jeder Verfahrposition des ersten und zweiten Trägers (3, 4) die Versorgungsleitung (5) zwischen dem zweiten Träger (4) und der Basis (2) wenigstens einen ersten Bogen (5.1) und zwischen dem ersten Träger (3) und dem zweiten Träger (4) wenigstens einen zweiten Bogen (5.2) ausbildet.

2. Vorrichtung nach Anspruch 1, wobei der zweite Träger (4) zwischen dem ersten Träger (3) und der Basis (2) angeordnet ist, und wobei der erste Bogen (5.1) und der zweite Bogen (5.2) unterschiedlich gekrümmt ausgebildet sind.

3. Vorrichtung nach Anspruch 1, wobei der erste Träger (3) zwischen dem zweiten Träger (4) und der Basis (2) angeordnet ist, und wobei der erste Bogen (5.1) und der zweite Bogen (5.2) identisch gekrümmt ausgebildet sind.

4. Vorrichtung nach einem der vorhergehenden Ansprüche, wobei die Versorgungsleitung (5) zwischen der Basis (2) und dem zweiten Träger (4) länger ausgebildet ist als zwischen dem ersten Träger (3) und dem zweiten Träger (4).

5. Vorrichtung nach einem der vorhergehenden Ansprüche, wobei der Krümmungsradius (R1) des ersten Bogens (5.1) größer ausgebildet ist als der Krümmungsradius (R2) des zweiten Bogens (5.2).

6. Vorrichtung nach einem der vorhergehenden Ansprüche, wobei der Verfahrweg (X₂; X₄; X₆) des ersten Trägers (3) kleiner ist als der Verfahrweg (X₁; X₃; X₅) des zweiten Trägers (4).

7. Vorrichtung nach einem der vorhergehenden Ansprüche, wobei die Versorgungsleitung (5) wenigstens einen Lichtleiter (6, 7) umfasst.

8. Vorrichtung nach Anspruch 7, wobei die Versorgungsleitung (5) neben dem wenigstens einen Lichtleiter (6, 7) zusätzlich mehrere Kabelstränge (8, 9) umfasst, welche parallel zum Lichtleiter (6, 7) angeordnet sind.

9. Vorrichtung nach einem der vorhergehenden Ansprüche, wobei die Versorgungsleitung (5) wenigstens zwischen dem ersten Träger (3) und dem zweiten Träger (4) freitragend ausgebildet ist.

10. Vorrichtung nach einem der vorhergehenden Ansprüche, wobei die Versorgungsleitung (5) von einem Verschleißschutzmittel (11) umgeben ist.

11. Vorrichtung nach einem der vorhergehenden Ansprüche, wobei die Versorgungsleitung (5) wenigstens ein Mittel (10, 11') zum Einhalten eines vorbestimmten Krümmungsintervalls umfasst.

12. Fertigungssystem zum Bearbeiten und/oder Prüfen von Halbleitersubstraten mit wenigstens einer Bewegungsvorrichtung (1) nach einem der Ansprüche 1 bis 11.
